# EUROPEAN PATENT SPECIFICATION

(11) **EP 3 633 065 B1**
(45) Date of publication and mention of the grant of the patent: **16.08.2023**
(21) Application number: 17900285.2
(22) Date of filing: 15.12.2017
(51) Int. Cl.: C23C 14/24, C23C 14/54, G01B 7/06

(54) **EVAPORATION DEVICE**
VERDAMPFUNGSVORRICHTUNG
DISPOSITIF D'ÉVAPORATION

(30) Priority: 22.05.2017 CN 201720572004 U
(43) Date of publication of application: 08.04.2020
(73) Proprietor: BOE Technology Group Co., Ltd., Beijing 100015 (CN); Hefei Xinsheng Optoelectronics Technology Co., Ltd., Xinzhan Industrial Park Hefei Anhui 230012 (CN)
(72) Inventor: GUO, Shupeng, Beijing 100176 (CN); HU, Changqi, Beijing 100176 (CN)
(74) Representative: Klunker IP Patentanwälte PartG mbB
(86) International application number: PCT/CN2017/116463
(87) International publication number: WO 2018/214483

(56) References cited:
- CN-A- 103 266 301
- CN-A- 103 305 796
- CN-A- 105 177 510
- CN-U- 205 774 772
- CN-U- 205 774 772
- CN-U- 205 999 474
- US-A1- 2009 142 489
- US-A1- 2012 114 837
- US-A1- 2016 122 861
- US-A1- 2017 268 096

## Description

### TECHNICAL FIELD

The present invention relates to an evaporation apparatus.

### BACKGROUND

With the development of display technology, organic light-emitting diode (OLED) display has gained attentions, increasingly, for its advantageous such as self-luminance, wide viewing angle, high resolution ratio, low power consumption and quick reaction speed.

The OLED is a light-emitting element including a plurality of types of functional layers which are stacked one on another. Currently, a manufacturing method of the OLED includes an evaporation process. That is, the functional layer of the OLED, e.g., an organic light-emitting layer, is evaporated by utilizing the evaporation process. Documents CN205774772 and US2012114837 disclose an evaporation apparatus comprising an evaporation source .

### SUMMARY

It is an object of the present invention to provide an evaporation apparatus.

The object is achieved by the features of the respective independent claim. Further embodiments are defined in the corresponding dependent claims.

### BRIEF DESCRIPTION OF THE DRAWINGS

Hereinafter, in order to clearly describe technical solutions of the embodiments in the present disclosure in a better way, the drawings of the embodiments will be briefly introduced. Obviously, the drawings to be described below merely relate to some embodiments of the present disclosure without any limitation to the present disclosure.
Fig. 1 is a structural diagram of an evaporation apparatus provided by an embodiment of the present disclosure;
Fig. 2 is a working principle diagram of an evaporation apparatus provided by an embodiment of the present disclosure;
Fig. 3 is an perspective schematic view of an evaporation apparatus provided by an embodiment of the present disclosure;
Fig. 4 is a structural diagram of another evaporation apparatus provided by an embodiment of the present disclosure;
Fig. 5 is a working principle diagram of another evaporation apparatus provided by an embodiment of the present disclosure; and
Fig. 6 is a schematic diagram illustrating a connecting relationship of a controller in an evaporation apparatus provided by an embodiment of the present disclosure.

### DETAILED DESCRIPTION

Hereinafter, the technical solutions in the embodiments of the present disclosure will be clearly, completely described with reference to the drawings in the embodiments of the present disclosure. Obviously, the embodiments described are only a part of the embodiments, not all embodiments. Based on the embodiments in the present disclosure, all other embodiments obtained by one skilled in the art without paying inventive labor are within the protection scope of the present disclosure.

Unless otherwise defined, all the technical and scientific terms used herein have the same meanings as commonly understood by one of ordinary skill in the art to which the present invention belongs. The terms "first," "second," etc., which are used in the present disclosure, are not intended to indicate any sequence, amount or importance, but distinguish various components. The phrases "comprise(s)" and "include(s)" etc., refer to that, an element or an object preceding this phrase encompasses element(s) or object(s) listed following this phrase, and equivalents thereof, without excluding the existence of other element(s) or object(s). The phrases "connect", "connected", etc., are not intended to define a physical connection or mechanical connection, but may include an electrical connection, directly or indirectly.

In study, inventors of the present application found that, in order to improve a performance of the OLED such as a capability of injecting and transmitting carriers, a luminous efficiency and a device lifetime, and also to manufacture OLED devices with different properties, it needs to adjust thicknesses of different functional layers in the OLED. Generally, a method of raising and lowering a temperature is adopted to change an evaporation rate of the evaporation source, so as to adjust a thickness of the functional layer to be formed. However, raising and lowering the temperature cost a relatively longer time, which may result in huge losses. Moreover, in an ordinary evaporation apparatus, electrical circuits such as signal transmission lines and control lines are all arranged as exposed lines, and involve problems such as a damage resulted by baking under high temperature and a sticking of evaporated material.

An embodiment of the present disclosure provides an evaporation apparatus. The evaporation apparatus includes an operation platform; an evaporation source on the operation platform; an inner plate; and an outer plate. The inner plate is on at least one side of the evaporation source, configured to be able to detect an evaporation rate of the evaporation source, and fixedly connected to the evaporation source. The outer plate is on a side of the inner plate away from the evaporation source and is adjacent to the inner plate; the outer plate is able to adjust an evaporation range. In this way, the evaporation apparatus can adjust an evaporation rate of the evaporation apparatus by adjusting the evaporation range of the evaporation source, so as to adjust a thickness of a film layer to be formed by evaporation, thereby achieving a quick adjustment of the thickness of the film layer to be formed by evaporation and improving a production efficiency.

Hereinafter the evaporation apparatus provided by the embodiments of the present disclosure will be described in conjunction with the drawings.

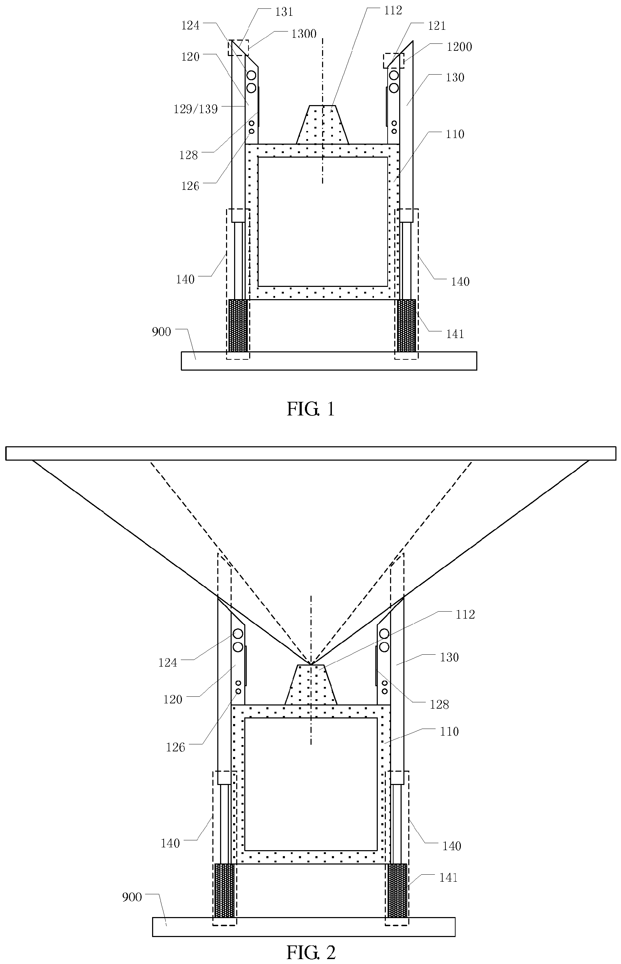

An embodiment of the present disclosure provides an evaporation apparatus. Fig. 1 is a structural diagram of an evaporation apparatus provided by an embodiment of the present disclosure. As illustrated in Fig. 1, the evaporation apparatus includes: an operation platform 900, an evaporation source 110 on the operation platform 900, an inner plate 120 and an outer plate 130. The inner plate 120 is on at least one side of the evaporation source 110, can detect an evaporation rate of the evaporation source 110, and is fixedly connected to the evaporation source 110. The outer plate 130 is on a side of the inner plate 120 away from the evaporation source 110 and is adjacent to the inner plate 120; the outer plate 130 can adjust an evaporation range.

In the evaporation apparatus provided by the embodiment of the present disclosure, the outer plate can limit the evaporation range of the evaporation source, e.g., the outer plate can move in a direction perpendicular to the operation platform, so as to change the evaporation range of the evaporation source. For example, given a same amount of evaporation material, when the evaporation range of the evaporation source is expanded, the evaporation material would be evaporated over a larger range, resulting in a reduced evaporation rate of the evaporation apparatus; when the evaporation range of the evaporation source is narrowed, the evaporation material would be evaporated over a smaller range, resulting in an increased evaporation rate of the evaporation apparatus. In this way, the evaporation apparatus can adjust the evaporation range of the evaporation source by driving the outer plate through the driving device, so as to be able to adjust the evaporation rate of the evaporation apparatus. By adjusting the evaporation rate of the evaporation apparatus, the thickness of the film layer to be formed by evaporation can be adjusted, so as to achieve quick adjustment of the thickness of the film layer to be formed by evaporation, thereby improving the production efficiency. It should be explained that, the evaporation rate mentioned above refers to an amount of evaporation material deposited on a unit area within a unit time period by the evaporation apparatus.

For example, in the evaporation apparatus provided by an embodiment of the present disclosure, as illustrated in Fig. 1, the inner plate 120 and the outer plate 130 are at two opposite sides of the evaporation source 110, respectively, so as to limit the evaporation range at two opposite sides of the evaporation source 110.

For example, in the evaporation apparatus provided by an embodiment of the present disclosure, as illustrated in Fig. 1, the evaporation apparatus further includes a driving device 140; the driving device 140 is connected to the outer plate 130 and can drive the outer plate 130 to adjust the evaporation range.

For example, in some examples, as illustrated in Fig. 1, the evaporation apparatus includes: an evaporation source 110, an inner plate 120, an outer plate 130 and a driving device 140. The evaporation source 110 includes at least one evaporation hole 112; an evaporation material can be heated in the evaporation source 110 and can be evaporated to leave through the evaporation hole 112; the inner plate 120 is disposed on the evaporation source 110 and located at both sides of the evaporation hole 112 a film thickness detector 128 is at least partially disposed inside the inner plate 120 ; ; the outer plate 130 is disposed at a side of the inner plate 120 away from the evaporation hole 112, that is, the outer plate 130 is disposed at an outside of the inner plate 120; the driving device 140 is connected to the outer plate 130, and the driving device 140 can drive the outer plate 130 to adjust the evaporation range. That is to say, the outer plate 130 can limit the evaporation range of the evaporation source 110, and the driving device 140 can be utilized to adjust the evaporation range of the evaporation source 110.

In the evaporation apparatus provided by the embodiment of the present disclosure, the outer plate can limit the evaporation range of the evaporation source, e.g., the outer plate can move in a direction perpendicular to the operation platform, so as to change the evaporation range of the evaporation source. For example, given a same amount of evaporation material, when the evaporation range of the evaporation source is expanded, the evaporation material would be evaporated over a larger range, resulting in a reduced evaporation rate of the evaporation apparatus; when the evaporation range of the evaporation source is narrowed, the evaporation material would be evaporated over a smaller range, resulting in an increased evaporation rate of the evaporation apparatus. In this way, the evaporation apparatus can adjust the evaporation range of the evaporation source by driving the outer plate through the driving device, so as to be able to adjust the evaporation rate of the evaporation apparatus. By adjusting the evaporation rate of the evaporation apparatus, the thickness of the film layer to be formed by evaporation can be adjusted, so as to achieve quick adjustment of the thickness of the film layer to be formed by evaporation, thereby improving the production efficiency. It should be explained that, the evaporation rate mentioned above refers to an amount of evaporation material deposited on a unit area within a unit time period by the evaporation apparatus.

For example, in the evaporation apparatus provided by the present embodiment, as illustrated in Fig. 1, the outer plate 120 and the inner plate 130 both extend along a direction parallel to a center line (as illustrated in Fig. 1) of the evaporation hole 112, an end of the outer plate 130 away from the evaporation source 110 extends beyond an end of the inner plate 120 away from the evaporation source 110, and the outer plate 130 can move along a direction parallel to the center line of the evaporation hole 112 with respect to the inner plate 120. In this way, the outer plate 130 can limit the evaporation range of the evaporation source 110; moreover, when the outer plate 130 moves along the direction parallel to the center line of the evaporation hole 112 with respect to the inner plate 120, the evaporation range of the evaporation source 110 can be changed. Fig. 2 is a working principle diagram of an evaporation apparatus provided by an embodiment of the present disclosure. As illustrated in Fig. 2, when the outer plate 130 moves upwards along the direction parallel to the center line of the evaporation hole 112 with respect to the inner plate 120 (the end of the outer plate 130 away from the evaporation source 110 is indicated by the dashed line in Fig. 2), in a plane illustrated in Fig. 2, an evaporation angle of the evaporation source 110 is decreased, that is, the evaporation range of the evaporation source 110 is narrowed. Similarly, when the outer plate 130 moves downwards along the direction parallel to the center line of the evaporation hole with respect to the inner plate 120, the evaporation range of the evaporation source is increased. In this way, the evaporation range of the evaporation source can be adjusted by moving the outer plate along the direction parallel to the center line of the evaporation hole with respect to the inner plate, so as to adjust the evaporation rate of the evaporation apparatus. Of course, the embodiments of the present disclosure include but not limited thereto, and the outer plate can adjust the evaporation range of the evaporation source by using other methods. It should be explained that, the direction parallel to the center line of the evaporation hole as illustrated in Fig. 1 is just the direction perpendicular to the operation platform.

For example, in the evaporation apparatus provided by an embodiment of the present disclosure, as illustrated in Fig. 1, the driving device 140 includes a lifting device 141; the lifting device 141 can drive the outer plate 140 to move along the direction parallel to the center line of the evaporation hole 112 so as to adjust a height of the outer plate 130 with respect to the operation platform 900. In this way, the outer plate can move along the direction parallel to the center line of the evaporation hole by the lifting device.

For example, the lifting device can include an air cylinder or a hydraulic device. Of course, the embodiments of the present disclosure include but not limited thereto, and the lifting device can also adopt other common structures, for example, the lifting device can realize ascending and descending movement by a lead screw and an electric motor.

For example, in the evaporation apparatus provided by an embodiment of the present disclosure, as illustrated in Fig. 1, the evaporation apparatus includes a film thickness detector 128. The film thickness detector 128 is at least partly disposed inside the inner plate 120, and can be configured to detect the evaporation rate of the evaporation apparatus. In this way, the evaporation rate of the evaporation apparatus can be detected by means of the film thickness detector. Because an evaporation time of a substrate to be evaporated can be determined, when the evaporation apparatus is used for evaporating a film layer onto a substrate to be evaporated, a thickness of the evaporated film layer can be calculated based on the evaporation rate. That is to say, the thickness of the evaporated film layer evaporated on the substrate to be evaporated can be obtained by obtaining the evaporation rate of the evaporation apparatus. When it needs to adjust the thickness of the evaporated film layer evaporated on the substrate to be evaporated, the outer plate can be adjusted directly according to a current evaporation rate detected by the film thickness detector so as to change the evaporate rate. For example, it's possible to drive the outer plate, by the driving device, to move along the direction parallel to the center line of the evaporation hole, until the current evaporation rate detected by the film thickness detector equaling to a desired evaporation rate. Additionally, the film thickness detector is partly located inside the inner plate, thus a circuit for connecting the film thickness detector to the outside can be completely disposed inside the inner plate so as to prevent the circuit for connecting the film thickness detector to the outside from any damage resulted by baking under high temperature and sticking of evaporated material.

For example, the film thickness detector can include a piezoelectric sensor. In this way, the film thickness detector can determine the evaporation rate of the evaporation apparatus according to a weight of evaporation material deposited onto the piezoelectric sensor within a unit time period. Of course, the embodiments of the present disclosure include but not limited thereto, and the film thickness detector can also adopt other structures and sensors to realize the detection of the evaporation rate of the evaporation apparatus.

For example, in the evaporation apparatus provided by an embodiment of the present disclosure, as illustrated in Fig. 1, the evaporation apparatus can further include a cooling device 124; the cooling device 124 is disposed inside the inner plate 120 and is configured to cool the film thickness detector 128. In this way, by cooling the film thickness detector through the cooling device, on one hand, it avoids an excessively high temperature of the film thickness detector so as to improve a detecting precision of the film thickness detector, and on the other hand, it provides a protection to the film thickness detector so as to extend a service life of the film thickness detector.

For example, the cooling device includes a cooling liquid pipeline. The film thickness detector is cooled by circulating the cooling liquid. For example, the cooling liquid can be water. Of course, the embodiments of the present disclosure include but not limited thereto, and the film thickness detector can also be cooled by adopting forced air cooling and other methods.

For example, in the evaporation apparatus provided by an embodiment of the present disclosure, as illustrated in Fig. 1, the evaporation apparatus further includes an electrical circuit 126. The electrical circuit 126 is disposed inside the inner plate 120 and is connected with the film thickness detector 128. For example, the electrical circuit 126 can include a power supply line, a control line, a signal transmission line, etc. of the film thickness detector. In this way, when the electrical circuit is disposed inside the inner plate, the inner plate can provide the electrical circuit with protection function so as to prevent the electrical circuit from any damage resulted by baking under high temperature and sticking of evaporated material.

For example, in the evaporation apparatus provided by an embodiment of the present disclosure, as illustrated in Fig. 1, a first surface 129 of the inner plate 120 facing the outer plate 130 is disposed to be in contact with a second surface 139 of the outer plate 130 facing the inner plate 120. In this way, it can avoid the evaporation material deposited between the inner plate and the outer plate, so as to prevent the outer plate from moving with respect to the inner plate.

For example, in the evaporation apparatus provided by an embodiment of the present disclosure, as illustrated in Fig. 1, an end 1200 of the inner plate 120 away from the evaporation source 110 includes a first inclined surface 121 biased to a side of the inner plate 120 close to the evaporation hole 112, that is, the first inclined surface 121 is biased to a side of the inner plate 120 close to the evaporation source 110. In this way, it can prevent the evaporation material from heavily depositing on an end of the inner plate away from the evaporation source.

For example, in the evaporation apparatus provided by an embodiment of the present disclosure, as illustrated in Fig. 1, an end 1300 of the outer plate 130 away from the evaporation source 110 includes a second inclined surface 131 biased to a side of the outer plate 130 close to the evaporation hole 112, that is, the second inclined surface 131 is biased to a side of the outer plate 130 close to the evaporation source 110. In this way, it can prevent the evaporation material from heavily depositing on an end of the outer plate away from the evaporation source.

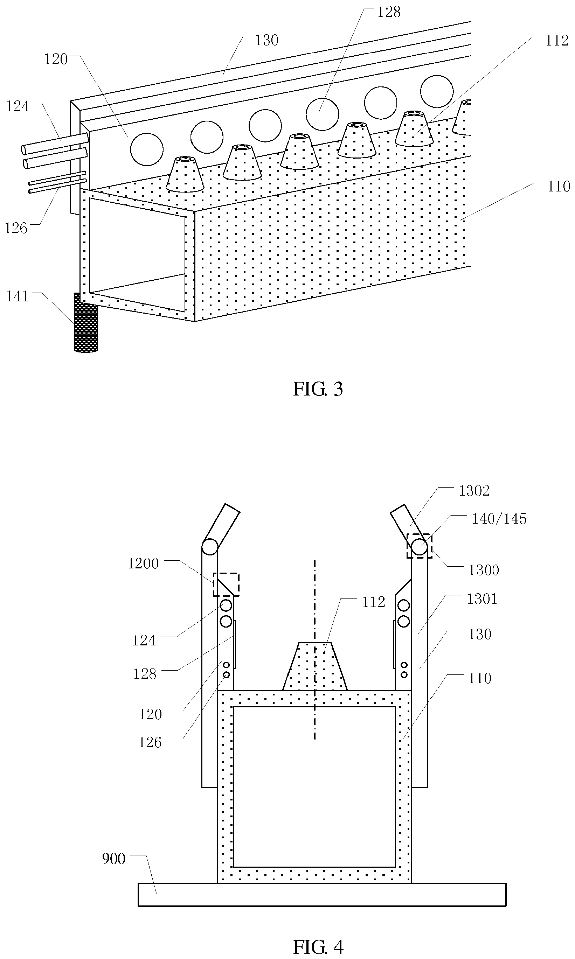

Fig. 3 is an elevation view of an evaporation apparatus provided by an embodiment of the present disclosure. As illustrated in Fig. 3, the evaporation apparatus includes an evaporation source 110, an inner plate 120, an outer plate 130 and a driving device 140. The evaporation source 110 includes at least one evaporation hole 112; an evaporation material can be heated in the evaporation source 110, and then evaporated to leave through the evaporation hole 112; the inner plate 130 is disposed on the evaporation source 110 and is located at both sides of the evaporation hole 112; the outer plate 130 is disposed at a side of the inner plate 120 away from the evaporation hole 112, that is, the outer plate 130 is disposed at an outer side of the inner plate 120; the driving device 140 is connected to the outer plate 130; the outer plate 130 is configured to limit an evaporation range of the evaporation source 110; the driving device 140 is configured to adjust the evaporation range of the evaporation source 110. In this way, the evaporation apparatus can adjust the evaporation range of the evaporation source by driving the outer plate through the driving device so as to adjust the evaporation rate of the evaporation apparatus. By adjusting the evaporation rate of the evaporation apparatus, the thickness of the film layer to be formed by evaporation can be adjusted, so as to realize a quick adjustment of the thickness of the film layer to be formed by evaporation, thereby improving the production efficiency. In addition, as illustrated in Fig. 3, the film thickness detector 128 is partly disposed inside the inner plate 120, that is, the film thickness detector 128 is embedded inside the inner plate 120; moreover, the electrical circuit 126 connected to the film thickness detector 128 is also disposed inside the inner plate 120. In this way, the evaporation apparatus can prevent the above-mentioned electrical circuit from any damage resulted by baking under high temperature and sticking of evaporated material, so as to enhance a stability of the evaporation apparatus and improve the service life of the evaporation apparatus. Additionally, as illustrated in Fig. 3, the evaporation apparatus is further provided with a cooling device for cooling the film thickness detector. In this way, the evaporation apparatus can cool the film thickness detector through the cooling device, which on one hand can avoid an excessively high temperature of the film thickness detector so as to improve the detecting precision of the film thickness detector, and on the other hand can provide the film thickness detector with a protection function so as to extend the service life of the film thickness detector.

For example, as illustrated in Fig. 3, the at least one evaporation hole 112 can include a plurality of evaporation holes 112 which are arranged in a line on the evaporation source 110. In this way, an evaporation process over a large area can be achieved by using the plurality of evaporation holes arranged in a line, so as to improve a uniformity of evaporation.

For example, as illustrated in Fig. 3, the evaporation apparatus can include a plurality of film thickness detectors 128; the plurality of film thickness detectors 128 can be disposed in one-to-one correspondence with the plurality of evaporation holes 112, so as to detect evaporation rates at locations of different evaporation holes 112.

An embodiment of the present disclosure provides an evaporation apparatus. Fig. 4 is a structural diagram of another evaporation apparatus provided by an embodiment of the present disclosure. Unlike the preceding embodiment, as illustrated in Fig. 4, in the present evaporation apparatus, the driving device 140 includes a rotating device 145; the outer plate 130 includes a main body part 1301 and a rotating part 1302. The main body part 1301 is disposed at a side of the inner plate 120 away from the evaporation hole 112; the main body part 1301 and the inner plate 120 both extend along a direction parallel to a center line (as illustrated in Fig. 4) of the evaporation hole 112; an end 1300 of the main body part 1301 away from the evaporation source 110 extends beyond an end 1200 of the inner plate 120 away from the evaporation source 110; an end of the rotating part 1302 is hinged with the end 1300 of the main body part 1301 away from the evaporation source 110 through a pivot, for example; the rotating device 145 is configured to drive the rotating part 1302 to rotate towards a direction close to the evaporation source 110. For example, as illustrated in Fig. 4, the rotating device 145 is disposed at a location where an end of the rotating part 1302 is hinged with the end 1300 of the man body part 1301 away from the evaporation source 110, so as to drive the rotating part 1302 to rotate towards a direction close to the evaporation source 110 and a direction away from the evaporation source 110. Of course, the embodiments of the present disclosure include but are not limited thereto, and the rotating device can also be disposed at other locations, as long as the rotating part can be driven towards a direction close to the evaporation source and a direction away from the evaporation source.

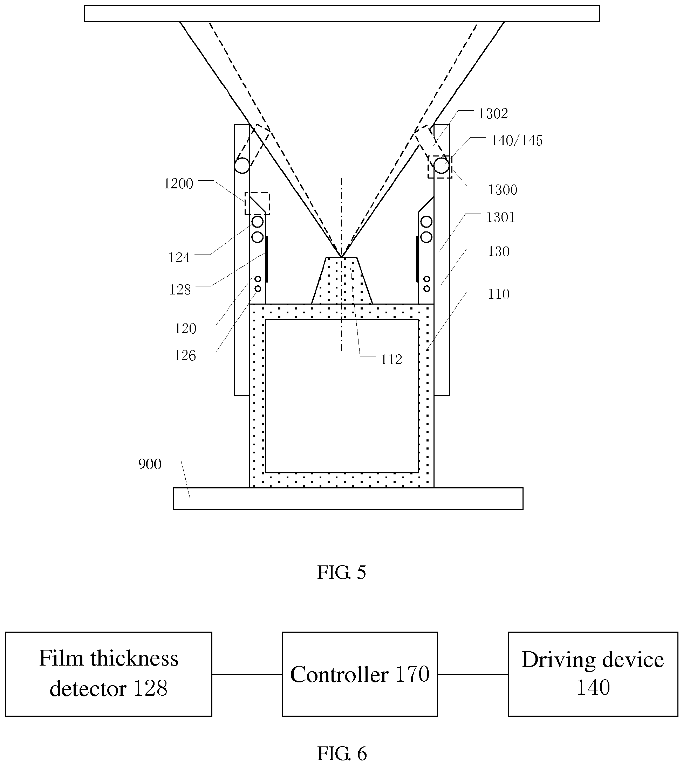

Fig. 5 is a working principle diagram of an evaporation apparatus provided by an embodiment of the present disclosure. As illustrated in Fig. 5, when the rotating part 1302 rotates towards the direction (as indicated by the dashed line in Fig.5) close to the evaporation source 110, the evaporation range of the evaporation source 110 is narrowed. Similarly, when the rotating part rotates towards the direction away from the evaporation source, the evaporation range of the evaporation source is expanded. In this way, the evaporation range of the evaporation source can be adjusted by driving the rotating part to rotate towards a direction close to the evaporation source and a direction away from the evaporation source, so as to adjust the evaporation rate of the evaporation apparatus.

It should be noted that, the driving device can also include both of the lifting device and the rotating device to drive the outer plate to perform ascending and descending movement and drive the rotating part to rotate, so as to jointly adjust the evaporation range of the evaporation source.

For example, Fig. 6 is a schematic diagram illustrating a connecting relationship of a controller in an evaporation apparatus provided by an embodiment of the present disclosure. As illustrated in Fig. 6, the evaporation apparatus further includes a controller 170 which is communicatively connected to the film thickness detector 128 and the driving device 140, respectively, by wires or wireless communication means (e.g., Wi-Fi), for example. The controller 170 can control the driving device 140 according to the evaporation rate detected by the film thickness detector 128. In this way, the controller can obtain the thickness of the evaporated film layer evaporated on the substrate to be evaporated just by obtaining the evaporation rate of the evaporation apparatus. When it needs to adjust the thickness of the evaporated film layer evaporated on the substrate to be evaporated, the controller can control the driving device to drive the outer plate directly according to the current evaporation rate detected by the film thickness detector, so as to change the evaporation rate. For example, it can drive the rotating part of the outer plate in the direction close to the evaporation source, by the rotating device of the driving device, until the current evaporation rate detected by the film thickness detector equaling to the desired evaporation rate.

The following statements should be noted:
(1) The accompanying drawings of the embodiments of the present disclosure involve only the structure(s) in connection with the embodiment(s) of the present disclosure, and other structure(s) can be referred to common design(s).
(2) In case of no conflict, features in one embodiment or in different embodiments of the present disclosure can be combined.

The foregoing are merely specific embodiments of the invention, but not limitative to the protection scope of the invention. Within the technical scope disclosed by the present disclosure, any alternations or replacements which can be readily envisaged by one skilled in the art shall be within the protection scope of the present disclosure. Therefore, the protection scope of the invention shall be defined by the accompanying claims.

## Claims

1. An evaporation apparatus, comprising:
an operation platform (900);
an evaporation source (110) on the operation platform (900);
an inner plate (120) on at least one side of the evaporation source (110), fixedly connected to the evaporation source (110); and
an outer plate (130) on a side of the inner plate (120) away from the evaporation source (110), being adjacent to the inner plate (120) and configured to adjust an evaporation range,
**characterized by**
a film thickness detector (128) at least partly disposed inside the inner plate (120), the film thickness detector (128) being configured to detect an evaporation rate of the evaporation apparatus.

2. The evaporation apparatus according to claim 1, wherein the inner plate (120) and the outer plate (130) are at two opposite sides of the evaporation source (110), respectively.

3. The evaporation apparatus according to claim 1 or 2, further comprising a driving device (140), wherein the driving device (140) is connected to the outer plate (130) and is configured to drive the outer plate (130) so as to adjust the evaporation range.

4. The evaporation apparatus according to claim 3, wherein the driving device (140) comprises a lifting device (141), the lifting device (141) is configured to drive the outer plate (130) to move along a direction away from the operation platform (900) so as to change a height of the outer plate (130) with respect to the operation platform (900).

5. The evaporation apparatus according to claim 3, wherein the driving device (140) comprises a rotating device (145),
the outer plate (130) comprises:
a main body part at a side of the inner plate (120) away from the evaporation source (110), the main body part and the inner plate (120) both extend along a direction perpendicular to the operation platform (900), an end of the main body part away from the evaporation source (110) extends beyond an end of the inner plate (120) away from the evaporation source (110); and
a rotating part (1302), an end of the rotating part (1302) is hinged with the end of the main body part away from the evaporation source (110),
wherein the rotating device (145) is configured to drive the rotating part (1302) towards a direction close to the evaporation source (110) and a direction away from the evaporation source (110).

6. The evaporation apparatus according to any one of claims 1-5, wherein the film thickness detector (128) comprises a piezoelectric sensor.

7. The evaporation apparatus according to claim 6, further comprising a controller (170), wherein
the controller (170) is communicatively connected to the film thickness detector (128) and the driving device (140), respectively, and is configured to control the driving device (140) according to the evaporation rate detected by the film thickness detector (128).

8. The evaporation apparatus according to claim 6, further comprising a cooling device (124), wherein
the cooling device (124) is disposed inside the inner plate (120) and is configured to cool the film thickness detector (128).

9. The evaporation apparatus according to claim 8, wherein the cooling device (124) comprises a cooling liquid pipeline.

10. The evaporation apparatus according to any one of claims 6-9, further comprising:
an electrical circuit (126) disposed inside the inner plate (120) and connected to the film thickness detector (128); optionally, the electrical circuit (126) comprises at least one of a power supply line and a signal transmission line.

11. The evaporation apparatus according to any one of claims 1-10, wherein a first surface of the inner plate (120) facing the outer plate (130) is disposed to be in contact with a second surface of the outer plate (130) facing the inner plate (120).

12. The evaporation apparatus according to any one of claims 1-11, wherein an end of the inner plate (120) away from the evaporation source (110) comprises a first inclined surface biased to a side of the inner plate (120) close to the evaporation source (110).

13. The evaporation apparatus according to any one of claims 1-12, wherein an end of the outer plate (130) away from the evaporation source (110) comprises a second inclined surface biased to a side of the outer plate (130) close to the evaporation source (110).

14. The evaporation apparatus according to any one of claims 1-13, wherein the evaporation source (110) comprises a plurality of evaporation holes (112), the plurality of evaporation holes (112) are arranged in a line on the evaporation source (110).

15. The evaporation apparatus according to any one of claims 6-13, wherein the evaporation source (110) comprises a plurality of evaporation holes (112), the plurality of evaporation holes (112) are arranged in a line on the evaporation source (110),
the evaporation apparatus comprises a plurality of film thickness detectors (128), the plurality of film thickness detectors (128) are disposed in one-to-one correspondence with the plurality of evaporation holes (112).

## Patentansprüche

1. Verdampfungsvorrichtung, mit:
einer Betriebsplattform (900);
einer Verdampfungsquelle (110) auf der Betriebsplattform (900):
einer Innenplatte (120) auf mindestens einer Seite der Verdampfungsquelle (110), die fest mit der Verdampfungsquelle (110) verbunden ist; und
einer Außenplatte (130) auf einer Seite der Innenplatte (120) weg von der Verdampfungsquelle (110), die an die Innenplatte (120) angrenzt und konfiguriert ist. einen Verdampfungsbereich einzustellen,
**gekennzeichnet durch**
einen Dünnschichtdickendetektor (128), der zumindest teilweise innerhalb der Innenplatte (120) angeordnet ist, wobei der Dünnschichtdickendetektor (128) konfiguriert ist. eine Verdampfungsrate der Verdampfungsvorrichtung zu erfassen.

2. Verdampfungsvorrichtung nach Anspruch 1, wobei sich die Innenplatte (120) und die Außenplatte (130) jeweils an zwei gegenüberliegenden Seiten der Verdampfungsquelle (110) befinden.

3. Verdampfungsvorrichtung nach Anspruch 1 oder 2, ferner mit einer Antriebseinrichtung (140), wobei die Antriebseinrichtung (140) mit der Außenplatte (130) verbunden und konfiguriert ist, die Außenplatte (130) anzutreiben, um so den Verdampfungsbereich einzustellen.

4. Verdampfungsvorrichtung nach Anspruch 3, wobei die Antriebseinrichtung (140) eine Hebeeinrichtung (141) aufweist, wobei die Hebeeinrichtung (141) konfiguriert ist. die Außenplatte (130) anzutreiben, um sie entlang einer Richtung weg von der Betriebsplattform (900) zu bewegen, um eine Höhe der Außenplatte (130) in Bezug auf die Betriebsplattform (900) zu ändern.

5. Verdampfungsvorrichtung nach Anspruch 3, wobei die Antriebseinrichtung (140) eine Drehvorrichtung (145) aufweist,
wobei die Außenplatte (130) aufweist:
einen Hauptkörperteil an einer von der Verdampfungsquelle (110) entfernten Seite der Innenplatte (120), wobei sich sowohl der Hauptkörperteil als auch die Innenplatte (120) entlang einer Richtung senkrecht zur Betriebsplattform (900) erstrecken, wobei ein von der Verdampfungsquelle (110) entferntes Ende des Hauptkörperteils über ein von der Verdampfungsquelle (110) entferntes Ende der Innenplatte (120) hinausragt: und
ein Drehteil (1302), wobei ein Ende des Drehteils (1302) mit dem von der Verdampfungsquelle (110) entfernten Ende des Hauptkörperteils gelenkig verbunden ist,
wobei die Drehvorrichtung (145) konfiguriert ist. das Drehteil (1302) in eine Richtung nahe der Verdampfungsquelle (110) und in eine Richtung weg von der Verdampfungsquelle (110) anzutreiben.

6. Verdampfungsvorrichtung nach einem der Ansprüche 1-5, wobei der Dünnschichtdickendetektor (128) einen piezoelektrischen Sensor aufweist.

7. Verdampfungsvorrichtung nach Anspruch 6, ferner mit einer Steuerung (170). wobei
die Steuerung (170) kommunikativ mit dem Dünnschichtdickcndetektor (128) bzw. der Antriebseinrichtung (140) verbunden und konfiguriert ist, die Antriebseinrichtung (140) in Abhängigkeit von der durch den Dünnschichtdickendetektor (128) erfassten Verdampfungsrate zu steuern.

8. Verdampfungsvorrichtung nach Anspruch 6. ferner mit einer Kühlvorrichtung (124). wobei
die Kühlvorrichtung (124) innerhalb der Innenplatte (120) angeordnet und konfiguriert ist, den Dünnschichtdickendetektor (128) zu kühlen.

9. Verdampfungsvorrichtung nach Anspruch 8, wobei die Kühlvorrichtung (124) eine Kühlflüssigkeitsleitung aufweist.

10. Verdampfungsvorrichtung nach einem der Ansprüche 6-9, ferner mit:
einer elektrischen Schaltung (126), die innerhalb der Innenplatte (120) angeordnet und mit dem Dünnschichtdickendetektor (128) verbunden ist; wobei die elektrische Schaltung (126) optional mindestens eine Stromleitung und/oder eine Signalübertragungsleitung aufweist.

11. Verdampfungsvorrichtung nach einem der Ansprüche 1-10. wobei eine erste Oberfläche der Innenplatte (120), die der Außenplatte (130) zugewandt ist, so angeordnet ist, dass sie mit einer zweiten Oberfläche derAußenplatte (130), die der Innenplatte (120) zugewandt ist, in Kontakt steht.

12. Verdampfungsvorrichtung nach einem der Ansprüche 1-1 1. wobei ein vonder Verdampfungsquelle (110) entferntes Ende der Inncnplatte (120) eine erste geneigte Oberfläche aufweist, die zu einer Seite der Innenplatte (120) nahe der Vcrdampfungsquelle (110) vorgespannt ist.

13. Verdampfungsvorrichtung nach einem der Ansprüche 1-12. wobei ein von der Verdampfungsquelle (110) entferntes Ende der Außenplatte (130) eine zweite geneigte Oberfläche aufweist, die zu einer Seite der Außenplatte (130) nahe der Verdampfungsquelle (110) hin vorgespannt ist.

14. Verdampfungsvorrichtung nach einem der Ansprüche 1-13. wobei die Verdampfungsquelle (110)eine Vielzahl von Verdampfungslöchern (112) aufweist, wobei die Vielzahl von Verdampfungslöchern (112) in einer Linie auf der Vcrdampfungsquelle (11()) angeordnet sind.

15. Verdampfungsvorrichtung nach einem der Ansprüche 6-13. wobei die Verdampfungsquelle (110) eine Vielzahl von Verdampfungslöchern (112) aufweist, wobei die Vielzahl von Verdampfungslöchern (112) in einer Linie auf der Verdampfungsquelle (110) angeordnet sind,
wobei die Verdampfungsvorriehtung eine Vielzahl von Dünnschiehldiekendetektoren (128) aufweist, wobei die Vielzahl von DÜnnschichtdickendetektoren (128) in eins-zu-cins-Entsprechung mit der Vielzahl von Verdampfungslöchern (112) angeordnet sind.

## Revendications

1. Appareil d'évaporation, comprenant :
une plate-forme opérationnelle (900) ;
une source d'évaporation (110) sur la plate-forme opérationnelle (900) ;
une plaque interne (120) sur au moins un côté de la source d'évaporation (110), connectée de façon fixe à la source d'évaporation (110) ; et
une plaque externe (130) sur un côté de la plaque interne (120) à distance de la source d'évaporation (110), qui est adjacente à la plaque interne (120) et configurée pour régler une plage d'évaporation,
**caractérisé par**
un détecteur d'épaisseur de film (128) au moins partiellement disposé à l'intérieur de la plaque interne (120), le détecteur d'épaisseur de film (128) étant configuré pour détecter un taux d'évaporation de l'appareil d'évaporation.

2. Appareil d'évaporation selon la revendication 1, dans lequel la plaque interne (120) et la plaque externe (130) sont respectivement au niveau de deux côtés opposés de la source d'évaporation (110).

3. Appareil d'évaporation selon la revendication 1 ou 2, comprenant en outre un dispositif d'entraînement (140), dans lequel le dispositif d'entraînement (140) est connecté à la plaque externe (130) et est configuré pour entraîner la plaque externe (130) de manière à régler la plage d'évaporation.

4. Appareil d'évaporation selon la revendication 3, dans lequel le dispositif d'entraînement (140) comprend un dispositif de levage (141), le dispositif de levage (141) est configuré pour entraîner la plaque externe (130) pour la déplacer suivant une direction d'éloignement par rapport à la plate-forme opérationnelle (900) de manière à modifier une hauteur de la plaque externe (130) par rapport à la plate-forme opérationnelle (900).

5. Appareil d'évaporation selon la revendication 3, dans lequel le dispositif d'entraînement (140) comprend un dispositif d'entraînement en rotation (145),
la plaque externe (130) comprend :
une partie de corps principale au niveau d'un côté de la plaque interne (120) à distance de la source d'évaporation (110), la partie de corps principale et la plaque interne (120) sont toutes deux étendues suivant une direction perpendiculaire à la plate-forme opérationnelle (900), et une extrémité de la partie de corps principale à distance de la source d'évaporation (110) est étendue au-delà d'une extrémité de la plaque interne (120) à distance de la source d'évaporation (110) ; et
une partie d'entraînement en rotation (1302), une extrémité de la partie d'entraînement en rotation (1302) est reliée par charnière à l'extrémité de la partie de corps principale à distance de la source d'évaporation (110),
dans lequel le dispositif d'entraînement en rotation (145) est configuré pour entraîner la partie d'entraînement en rotation (1302) suivant une direction de rapprochement par rapport à la source d'évaporation (110) et une direction d'éloignement par rapport à la source d'évaporation (110).

6. Appareil d'évaporation selon l'une quelconque des revendications 1 à 5, dans lequel le détecteur d'épaisseur de film (128) comprend un capteur piézoélectrique.

7. Appareil d'évaporation selon la revendication 6, comprenant en outre un contrôleur (170), dans lequel
le contrôleur (170) est respectivement connecté en termes de communication au détecteur d'épaisseur de film (128) et au dispositif d'entraînement (140) et est configuré pour commander le dispositif d'entraînement (140) en fonction du taux d'évaporation détecté par le détecteur d'épaisseur de film (128).

8. Appareil d'évaporation selon la revendication 6, comprenant en outre un dispositif de refroidissement (124), dans lequel
le dispositif de refroidissement (124) est disposé à l'intérieur de la plaque interne (120) et est configuré pour refroidir le détecteur d'épaisseur de film (128).

9. Appareil d'évaporation selon la revendication 8, dans lequel le dispositif de refroidissement (124) comprend un conduit de liquide de refroidissement.

10. Appareil d'évaporation selon l'une quelconque des revendications 6 à 9, comprenant en outre :
un circuit électrique (126) disposé à l'intérieur de la plaque interne (120) et connecté au détecteur d'épaisseur de film (128) ; en option, le circuit électrique (126) comprend au moins une ligne parmi une ligne d'alimentation en énergie électrique et une ligne de transmission de signal.

11. Appareil d'évaporation selon l'une quelconque des revendications 1 à 10, dans lequel une première surface de la plaque interne (120) qui fait face à la plaque externe (130) est disposée pour être en contact avec une seconde surface de la plaque externe (130) qui fait face à la plaque interne (120).

12. Appareil d'évaporation selon l'une quelconque des revendications 1 à 11, dans lequel une extrémité de la plaque interne (120) à distance de la source d'évaporation (110) comprend une première surface inclinée dont l'inclinaison est en direction d'un côté de la plaque interne (120) selon un rapprochement par rapport à la source d'évaporation (110).

13. Appareil d'évaporation selon l'une quelconque des revendications 1 à 12, dans lequel une extrémité de la plaque externe (130) à distance de la source d'évaporation (110) comprend une seconde surface inclinée dont l'inclinaison est en direction d'un côté de la plaque externe (130) selon un rapprochement par rapport à la source d'évaporation (110).

14. Appareil d'évaporation selon l'une quelconque des revendications 1 à 13, dans lequel la source d'évaporation (110) comprend une pluralité d'orifices d'évaporation (112), et les orifices de la pluralité d'orifices d'évaporation (112) sont agencés selon une ligne sur la source d'évaporation (110).

15. Appareil d'évaporation selon l'une quelconque des revendications 6 à 13, dans lequel la source d'évaporation (110) comprend une pluralité d'orifices d'évaporation (112), et les orifices de la pluralité d'orifices d'évaporation (112) sont agencées selon une ligne sur la source d'évaporation (110),
l'appareil d'évaporation comprend une pluralité de détecteurs d'épaisseur de film (128), et les détecteurs de la pluralité de détecteurs d'épaisseur de film (128) sont disposés selon une correspondance biunivoque par rapport aux orifices de la pluralité d'orifices d'évaporation (112).
